# EUROPEAN PATENT SPECIFICATION

(11) **EP 2 372 744 B1**
(45) Date of publication and mention of the grant of the patent: **13.01.2016**
(21) Application number: 10159022.2
(22) Date of filing: 01.04.2010
(51) Int. Cl.: H01J 37/34

(54) **Device for supporting a rotatable target and sputtering installation**
Vorrichtung zum Stützen eines drehbaren Targets und Sputter-Installation
Dispositif pour supporter une cible rotative et installation de pulvérisation

(43) Date of publication of application: 05.10.2011
(73) Proprietor: Applied Materials, Inc., Santa Clara, CA 95054 (US)
(72) Inventor: Schnappenberger, Frank, 55218 Ingelheim (DE)
(74) Representative: Zimmermann & Partner Patentanwälte mbB

(56) References cited:
- WO-A1-2007/147757
- US-A1- 2005 178 662
- US-A1- 2008 128 276

## Description

### FIELD OF THE INVENTION

The present disclosure relates to a device for supporting a rotatable target, particularly to a device having a main body, a first fluid conduit for receiving a fluid from the rotatable target and a second fluid conduit for providing the fluid to the rotatable target. Further, the present disclosure relates to a sputtering installation including device for supporting a rotatable target.

### BACKGROUND OF THE INVENTION

In many applications it is desired to deposit thin layers on a substrate. Known techniques for depositing thin layers are in particular evaporating, chemical vapor sputtering and sputtering deposition. For example, sputtering can be used to deposit a thin layer such as a thin layer of a metal, e.g. aluminum, or ceramics. During the sputtering process, the coating material is transported from a sputtering target consisting of that material to the substrate to be coated by bombarding the surface of the target with ions of a typically inert processing gas at low pressure. The ions are produced by electron impact ionization of the processing gas and accelerated by a high voltage drop between the target operating as a sputtering cathode and an anode. This bombardment of the target results in the ejection of atoms or molecules of the coating material, which accumulate as a deposited film on the substrate arranged opposite to the sputtering cathode, e.g. below the sputtering cathode.

Segmented planar, monolithic planar and rotatable targets may be used for sputtering. Due to the geometry and design of the cathodes, rotatable targets typically have a higher utilization and an increased operation time than planar ones. Accordingly, the use of rotatable targets typically prolongs service lives and reduces costs.

The rotary cathode is typically supported by a cathode drive unit of the sputtering installation. In the following the cathode drive unit is also referred to as an end-block and a cathode drive-block, respectively. During sputtering, the cathode drive unit rotatably transfers movement to the rotary cathode. Given longitudinal extensions of rotary cathodes of up to about 4 m and typical continuous operation times of sputtering installations of several days, the bearing of the cathode drive unit is typically desired to reliably bear heavy mechanical loads over a long period of time.

Document US 2008/0128276 A1 describes a supply end block according to the preamble of claim 1 including a housing with a coolant connection and a current connection as well as a support shaft.

Document US 2005/0178662 A1 describes a device for supporting a rotatable target comprising a fluid conduit extending radially outward from the rotational axis.

Sputtering is typically carried out under low pressure or vacuum condition, i.e. in a vacuum chamber. For cost reasons, cathode drive units, in particular when arranged within a vacuum chamber of a sputtering installation, are typically also desired to have low space requirements. Accordingly, there is an ongoing need for improved cathode drive units, in particular compact cathode drive units.

### BRIEF DESCRIPTION

In view of the above a device for supporting a rotatable target and a deposition apparatus having at least one device for supporting a rotatable target are provided.

According to an embodiment, a device arranged to support a rotatable target of a deposition apparatus for sputtering material on a substrate, the device having a longitudinal axis forming a rotational axis of the rotatable target is provided. The rotatable target defines a rotational axis. The device includes a main body, a first fluid conduit in the main body and a second fluid conduit in the main body. The first fluid conduit is adapted to receive a fluid from the rotatable target and orientated in a direction which is orthogonal to the rotational axis. The second fluid conduit is adapted for providing the fluid to the rotatable target and orientated in a direction which is orthogonal to the rotational axis. The projections of the first fluid conduit and the second fluid conduit onto a projection plane that extends in the direction of the rotational axis overlap each othercharacterized in that one of the first fluid conduit and the second fluid conduit extends radially outward from the rotational axis.

According to an embodiment, a deposition apparatus for sputtering material on a substrate is provided. The deposition apparatus includes at least one device arranged to support a rotatable target. The device includes a main body, a first fluid conduit in the main body and a second fluid conduit in the main body. The first fluid conduit is adapted to receive a fluid from the rotatable target and orientated in a direction which is orthogonal to the rotational axis. The second fluid conduit is adapted for providing the fluid to the rotatable target and orientated in a direction which is orthogonal to the rotational axis. The projections of the first fluid conduit and the second fluid conduit onto a projection plane that extends in the direction of the rotational axis overlap each other characterized in that one of the first fluid conduit and the second fluid conduit extends radially outward from the rotational axis.

According to an example, an end-block for supporting a rotatable target defining a rotational axis is provided. The end-block includes a main body, a first fluid conduit adapted for fluid connection with the main body at a first axial co-ordinate and at least a second fluid conduit adapted for fluid connection with the main body at a second axial co-ordinate. The first fluid conduit has a first outer diameter. A distance between the first axial co-ordinate and the second axial co-ordinate is less than the first outer diameter.

Further aspects, advantages and features of the present invention are apparent from the dependent claims, the description and the accompanying drawings.

### BRIEF DESCRIPTION OF THE DRAWINGS

Some of the above mentioned embodiments will be described in more detail in the following description of typical embodiments with reference to the following drawings in which:
Fig. 1 shows schematically a cross-section of a device for supporting a rotatable target along an axis which is a rotational axis according to embodiments;
Fig. 2 shows schematically a cross-section of a device for supporting a rotatable target along an axis which is a rotational axis according to embodiments;
Fig. 3 shows schematically a cross-section of a device for supporting a rotatable target along an axis which is a rotational axis according to embodiments;
Fig. 4 shows schematically a cross-section of a device for supporting a rotatable target along an axis which is a rotational axis according to embodiments;
Fig. 5 shows schematically a cross-section of a device for supporting a rotatable target along an axis which is a rotational axis according to embodiments;
Fig. 6 shows schematically a cross-section of a device for supporting a rotatable target along an axis which is a rotational axis according to embodiments;
Fig. 7 shows schematically a cross-section of a device for supporting a rotatable target along an axis which is a rotational axis according to embodiments;
Fig. 8 shows schematically a cross-section of a device for supporting a rotatable target along an axis which is a rotational axis according to embodiments;
Fig. 9 shows schematically a cross-section of a device for supporting a rotatable target along a rotational axis according to embodiments;
Fig. 10 shows schematically a cross-section of a device for supporting a rotatable target along a rotational axis according to embodiments;
Fig. 11 shows schematically a cross-section of a device for supporting a rotatable target along the line A-A' of Fig. 9 according to embodiments;
Fig. 12 shows schematically a perspective view of an inner part of a device for supporting a rotatable target according to embodiments.
Fig. 13 shows schematically a perspective view of an inner part of a device for supporting a rotatable target according to embodiments.
Fig. 14 shows schematically a cross-section of a sputtering installation according to embodiments;
Fig. 15 shows schematically a cross-section of a sputtering installation according to embodiments;
Fig. 16 shows schematically a cross-section of a sputtering installation according to embodiments;

The elements of the drawing are not necessarily to scale relative to each other. Like reference numerals designate corresponding similar parts.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations, the invention being defined by the claims.

Sputtering is a process in which atoms are ejected from a solid target material due to bombardment of the target by energetic particles. The process of coating a substrate as a material at the scraping refers typically to thin film applications. The term "coating" and the term "depositing" are used synonymously herein. The terms "sputtering installation" and "deposition apparatus" are used synonymously herein and shell embrace an apparatus which uses sputtering for depositing a target material, typically as a thin film, on a substrate.

Typical target materials include (but are not limited to) pure metals such as aluminum (Al), copper (Cu), silver (Ag) and gold (Au), metal alloys such as such as an aluminum-niobium (AINb) alloy or an aluminum-nickel (AINi) alloy, semiconductor materials such as silicon (Si) and dielectric materials such as nitrides, carbides, titanates, silicates, aluminates and oxides, e.g. transparent conducting oxides (TCO) such as impurity-doped ZnO, e.g. ZnO:Al, AlZnO, In₂O₃, SnO₂ and CdO, as well as Sn doped In₂O₃ (ITO) and F doped SinO₂.

The term "substrate" as used herein shall embrace both inflexible substrates, e.g. a wafer or a glass plate, and flexible substrates such as webs and foils.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

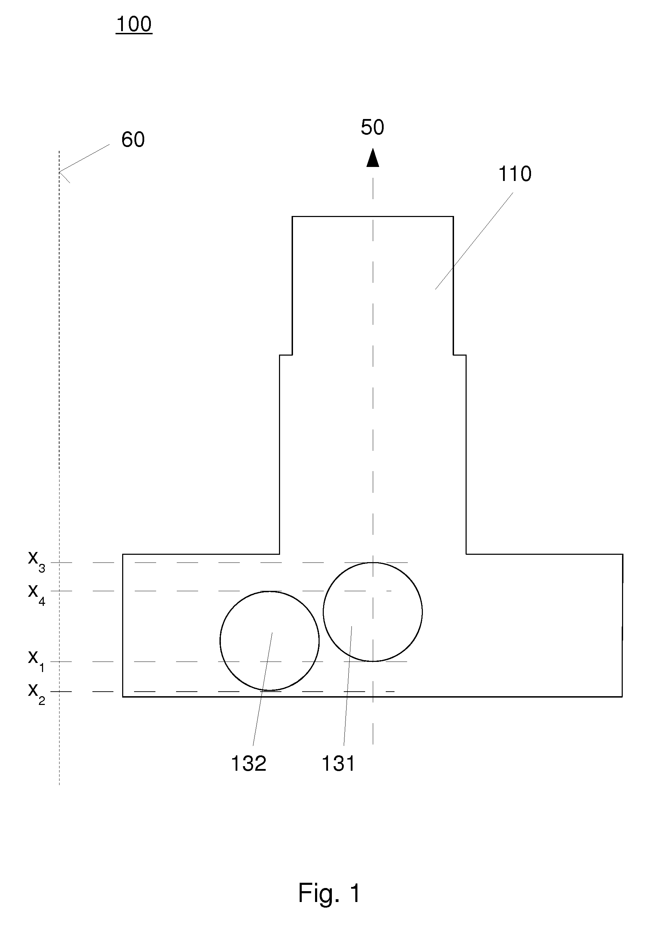

With respect to Fig. 1, several embodiments pertaining to devices for supporting a rotatable target of a deposition apparatus are explained. The term "device for supporting a rotatable target" as used herein shall embrace a device which is adapted to mechanically support a rotatable target, to rotatably transfers movement to the rotatable target and to provide a coolant for the rotatable target. The terms "device for supporting a rotatable target", "end-block", "cathode drive-head" and the term "cathode drive-block" are used synonymously herein. The terms "device for supporting a rotatable target", "end-block", "cathode drive-head" and "cathode drive-block" as used herein shall particularly embrace devices which provide coolant and/or electrical current to the rotatable target while maintaining vacuum integrity and a closed coolant circuit.

The term "rotatable target" as used herein shall embrace any cathode assembly which is adapted to be rotatably mounted to a sputtering installation and which includes a target structure adapted for being sputtered. The term "rotatable target" as used herein shall particularly embrace magnetically enhanced cathode assemblies which in addition include internal magnetic means, e.g. permanent magnets, for improved sputtering.

Rotatable targets, in the following also referred to as rotatable sputtering cathodes and rotary cathodes, respectively, may be made of a hollow cylindrical body of the target material. These rotary targets are also referred to as monolithic targets and may be manufactured by casting or sintering of the target material.

Non-monolithic rotatable targets typically include a cylindrical rotatable tube, e.g. a backing tube, having a layer of the target material applied to the outer surface thereof. In the manufacture of such rotatable sputtering cathodes, the target material may for example be applied by spraying onto, or casting or isostatic pressing of powder onto the outer surface of a backing tube. Alternatively, a hollow cylinder of a target material, which may also be referred to as a target tube, may be arranged on and bonded, e.g. with indium, to the backing tube for forming a rotary cathode. According to yet further alternatives, non-bonded target cylinders can be provided radially outward of a backing tube.

In order to obtain increased deposition rates, the use of magnetically enhanced cathodes has been proposed. This may also be referred to as magnetron sputtering. Magnetic means, which may include an array of magnets, may be arranged inside the sputtering cathode, e.g. inside a backing tube or inside a monolithic target, and provide a magnetic field for magnetically enhanced sputtering. The cathode is typically rotatable about its longitudinal axis so that it can be turned relative to the magnetic means.

In operation, un-cooled magnets may become hot. This is due to the fact that they are surrounded by target material that is bombarded with ions. The resulting collisions lead to a heating up of the rotary cathode. In order to keep the magnets at a suitable operating temperature, a cooling of the target material and the magnets may be provided.

Fig. 1 shows schematically an end-block 100 in a typical cross-section along a direction which is parallel to a rotational axis 50 defined by a rotatable target (not shown). During sputtering, the rotatable target may rotate around the rotational axis 50. The rotational axis 50 also forms a longitudinal axis 50 of the end-block 100 and defines an axial direction. In this regard, directional terminology, such as "top," "bottom," "upper," "lower," "above," "below," "on," etc., is used with reference to the orientation of the rotational axis 50. The term "axial direction" as used herein intends to describe a direction which is parallel to the rotational axis 50. Likewise, the term "radial direction" as used herein intends to describe a direction which is orthogonal to the rotational axis 50 and points away from the rotational axis 50. The term "axial co-ordinate" as used herein intends to describe a co-ordinate in direction of the rotational axis 50. The axial co-ordinate of a point is typically given by the orthogonal projection of the point onto the rotational axis 50. Likewise, the term "axial distance" as used herein intends to describe the distance in direction of the rotational axis 50. Larger values of the axial co-ordinate correspond to a shorter axial distance to the rotatable target. The term "axial extension" as used herein intends to describe the extension in direction of the rotational axis 50. The "axial extension" of a part is typically given by the difference between a "maximum axial co-ordinate" and a "minimum axial co-ordinate" of a part.

According to embodiments, the end-block 100 has a base body 110, typically a hollow base body 110, a first fluid conduit 131 and a second fluid conduit 132. The term "fluid conduit" as used herein intends to describe a fluid channel and a tube adapted to carry a fluid flow, respectively. The first fluid conduit 131 and the second fluid conduit 132 are orientated perpendicular to the rotational axis 50.

The rotatable target 50 is typically arranged above the main body 110 for sputtering. During sputtering the second fluid conduit 132 provides a coolant, typically water, to a radially inward lying part of the base body 110. The coolant is typically fed upwards through the inward lying part of the base body 110 to the rotatable target 50 and downwards from the rotatable target 50 through the inward lying part of the base body 110. The first fluid conduit 131 receives the warmed up coolant from the radially inward lying part of the base body 110. Typically, the first fluid conduit 131 and the second fluid conduit 132 are part of a closed coolant circuit for cooling the rotatable target during sputtering.

According to embodiments, the orthogonal projections of the first fluid conduit 131 and the second fluid conduit 132 onto a projection plane 60 that extends in the direction of the rotational axis 50 overlap each other.

In other words, the first fluid conduit 131 extends in the cross-section of Fig. 1 between a first minimum axial co-ordinate x₁ and a first maximum axial co-ordinate x₃. The second fluid conduit 132 extends in the cross-section of Fig. 1 between a second minimum axial co-ordinate x₂ and a second maximum axial co-ordinate x₄, wherein at least one of the second minimum axial co-ordinate x₂ and the second maximum axial co-ordinate x₄ lies between the first minimum axial co-ordinate x₁ and the first maximum axial co-ordinate x₃. This means that at least one of the conditions x₁ ≤ x₄ ≤ x₃ and x₁ ≤ x₂ ≤ x₃ is fulfilled. Arranging the first and the second fluid conduit 131, 132 in such a manner results in a compact and space reduced design of the end-block 100. Thereby, space within the process chamber of the deposition apparatus and hence costs can be reduced.

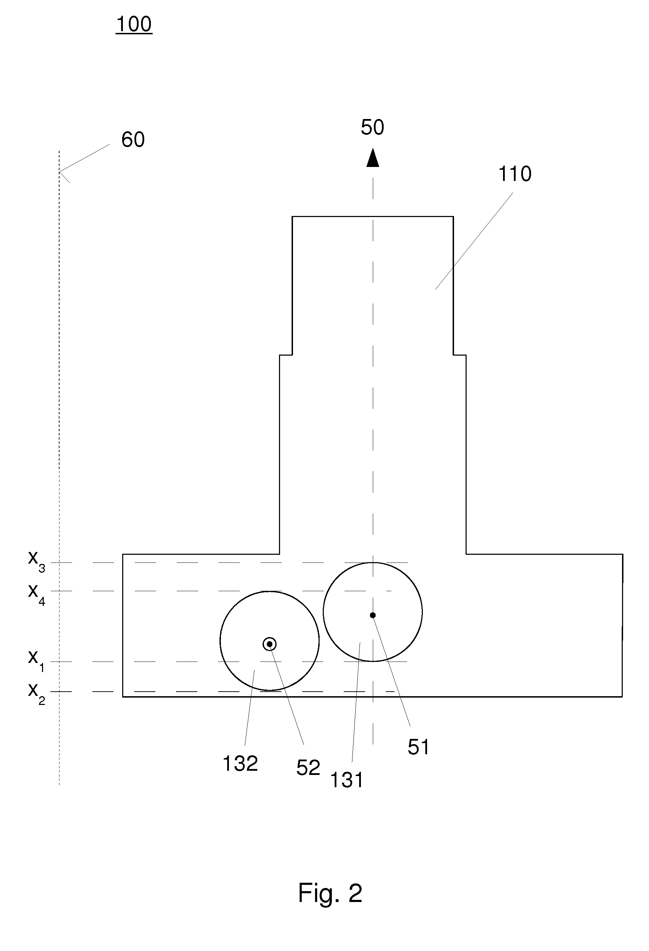

Fig. 2 shows schematically a cross-section of an end-block 100 along a direction which is parallel to the rotational axis 50 of the rotatable target according to embodiments. The end-block 100 of Fig. 2 is similar to the end-block 100 of Fig. 1. Most of the elements in Fig. 2 are similar to the corresponding elements in Fig. 1. For sake of clarity, these elements are referred to with the same respective reference numbers.

According to embodiments, the first fluid conduit 131 extends radially outward from the rotational axis 50. This is indicated in Fig. 2 by a first longitudinal axis 51 of the first fluid conduit 131 which orientated in a radial direction. In these embodiments, the second fluid conduit 132 includes a second longitudinal axis 52 which is typically parallel to the first longitudinal axis 51.

According to other embodiments which are not shown in Fig. 2, the second fluid conduit 132 extends radially outward from the rotational axis 50. In these embodiments, the second longitudinal axis 52 of the second fluid conduit 132 is radial with respect to the rotational axis 50 and the first longitudinal axis 51 is typically parallel to the second longitudinal axis 52.

The first and second fluid conduits 131, 132 and the first and second fluid channels 131, 132, respectively, are typically of tubular shape. In this case, the respective outer boundaries are circles in cross-sections which are parallel to the rotational axis 50. The first and/or the second fluid conduit 131, 132 may however also be formed as an ellipse or a polygon in cross-sections which are parallel to the rotational axis 50. In these cross-sections, the longitudinal axes 51 and 52 typically go through the centre of area of the respective fluid conduit.

According to embodiments, the first longitudinal axes 51 and the second longitudinal axes 52 are parallel to each other as shown in Fig. 2. Note that the second longitudinal axes 52 and the first longitudinal axes 51 point into the shown cross-section and out of the shown cross-section. This corresponds to the typical flow direction through the first and second fluid conduits 131, 132 during sputtering.

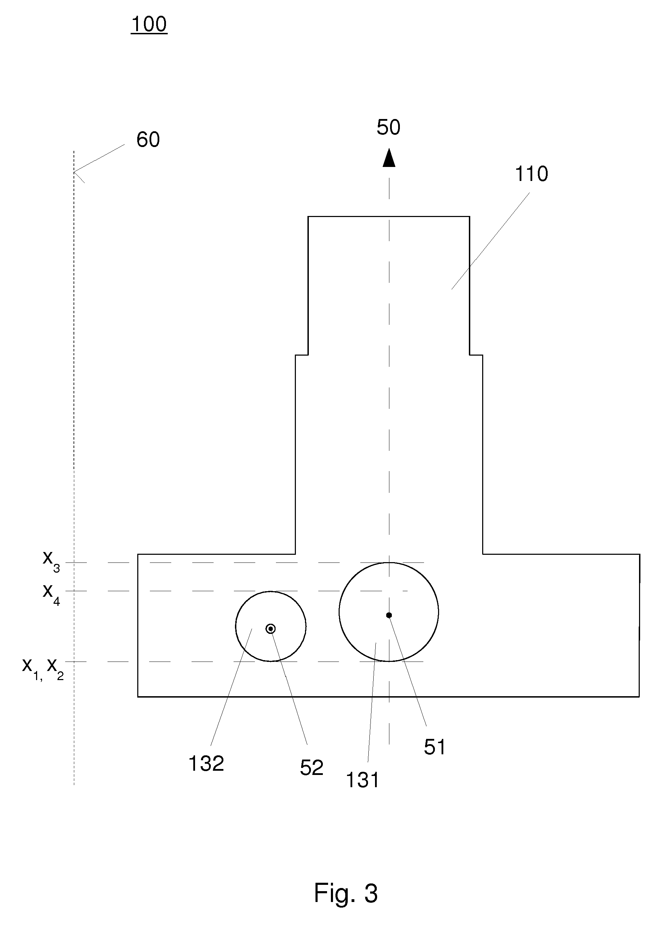

Fig. 3 shows schematically a cross-section of an end-block 100 along a direction which is parallel to the rotational axis 50 of the rotatable target according to embodiments. The end-block 100 of Fig. 3 is similar to the end-blocks 100 of Fig. 1 and Fig. 2. According to embodiments, the second minimum axial co-ordinate x₂ and the second maximum axial co-ordinate x₄ lies between the first minimum axial co-ordinate x₁ and the first maximum axial co-ordinate r₃. This means that both conditions x₁ ≤ x₄ ≤ x₃ and x₁ ≤ x₂ ≤ x₃ are fulfilled. In other words, the projection of the second conduit 132 onto the projection plane 60 lies completely in the projection of the first conduit 131 onto the projection plane 60.

According to embodiments, the cross-sectional area of the first and second fluid conduits 131, 132 are substantially equal. Thereby, the fluid flow in both conduits 131, 132 are substantially equal when the same number of coolant inflows and coolant outflows are provided.

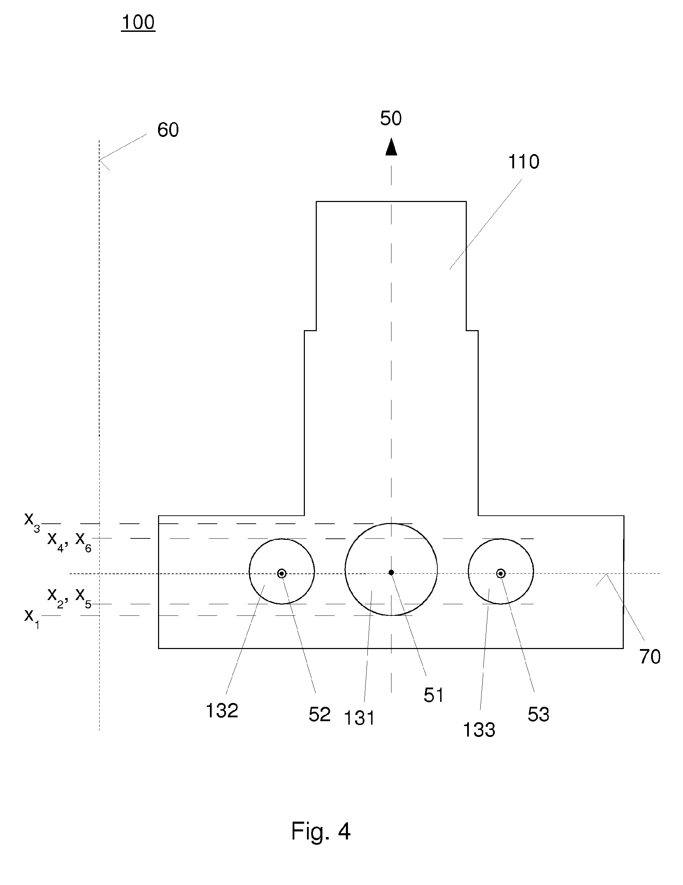

Fig. 4 shows schematically a cross-section of an end-block 100 along a direction which is parallel to the rotational axis 50 of the rotatable target according to embodiments. The end-block 100 of Fig. 4 is similar to the end-blocks 100 of Fig. 1 to Fig. 3. According to embodiments, the end-block 100 of Fig. 4 further includes a third fluid conduit 133 in the main body 110 for fluid support of the rotatable target. The third conduit 133 is oriented orthogonally to the rotational axis 50 and the projections of the first fluid conduit 131 and the third fluid conduit 133 onto the projection plane 60 overlap each other. Figure 4 illustrates embodiments in which the projection of the third fluid conduit 133 lies within the projection of the first fluid conduit 131. In other words, the third fluid conduit 133 extends in the cross-section of Fig. 4 between a third minimum axial co-ordinate x₅ and a third maximum axial co-ordinate x₆, wherein both conditions x₁ ≤ x₅ ≤ x₃ and x₁ ≤ x₆ ≤ x₃ are fulfilled. Typically, the third conduit 133 is also adapted to provide a coolant to the radially inward lying part of the base body 110. Further, a third longitudinal axis 53 of the third conduit 133 is typically also parallel to at least one of the first longitudinal axis 51 and the second longitudinal axis 52.

According to embodiments, the sum of the sectional areas of the second fluid conduit 132 and the third fluid conduit 133 approximately matches the sectional area of the first fluid conduit 131. Thereby, the average fluid velocity in the coolant providing conduits 132 and 133 is approximately the same as in coolant discharging conduit 131. With two coolant providing conduits 132 and 133 and one central coolant discharging conduit 131 a particularly compact end-block 100 may be realized.

According to embodiments, the second and third longitudinal axes 52, 53 are arranged in a virtual plane 70 which is orthogonal to the rotational axis 50. This is also useful to realize a particularly compact end-block 100. Furthermore, the first longitudinal axis 51 may also be arranged in the plane 70.

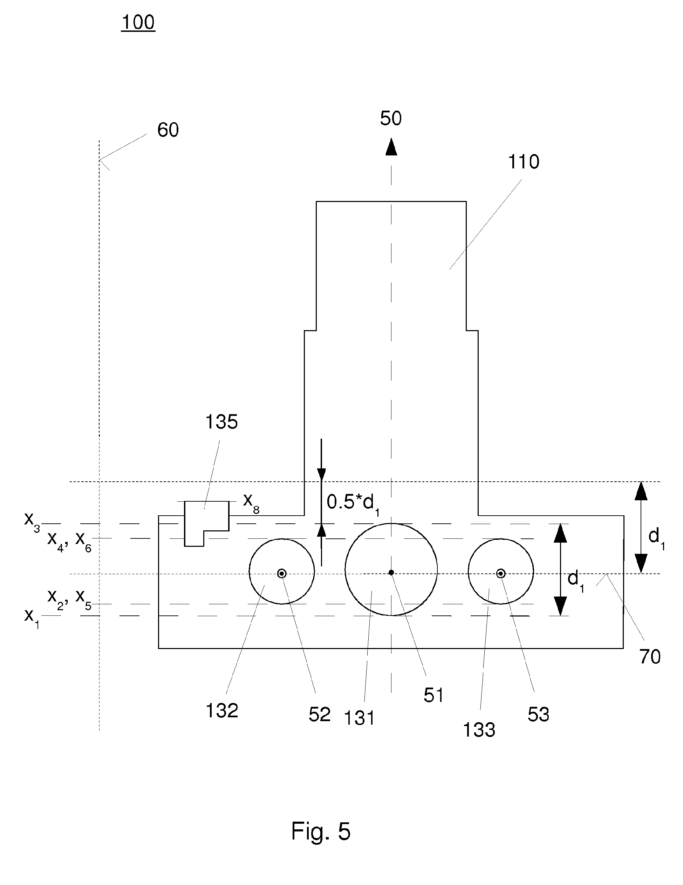

Fig. 5 shows schematically a cross-section of an end-block 100 along a direction which is parallel to the rotational axis 50 of the rotatable target according to embodiments. The end-block 100 of Fig. 5 is similar to the end-blocks 100 of Fig. 1 to Fig. 4. According to embodiments, the end-block 100 of Fig. 4 further includes at least one electric contact 135, typically several sliding electric contacts 135 for providing an appropriate voltage to the rotatable target such that the rotatable target may be operated as a cathode during sputtering. To ensure a compact design of the end-block 100, the at least one electric contact 135 has a maximum axial co-ordinate x₈. The maximum axial co-ordinate x₈ is typically smaller than the sum of the first maximum axial co-ordinate x₃ and half of a first axial extension d₁ of the first fluid conduit, i.e. x₈ < x₃ + 0.5 *d₁ = 1.5 x₃ - 0.5 *x₁. In the case of a tubular fluid conduit 131, the first axial extension d₁ is also referred to as first diameter d₁.

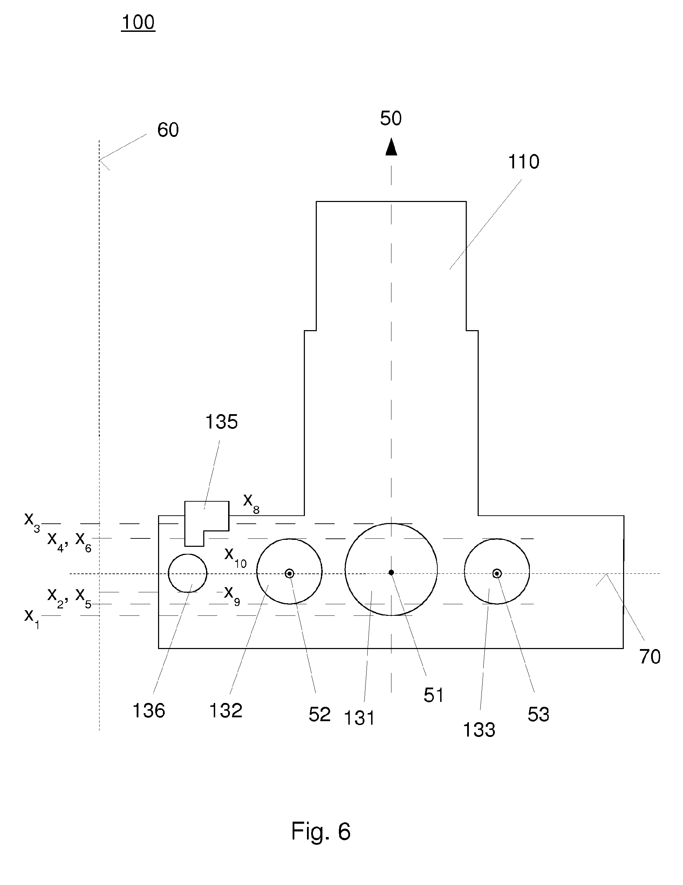

Fig. 6 shows schematically a cross-section of an end-block 100 along a direction which is parallel to the rotational axis 50 of the rotatable target according to embodiments. The end-block 100 of Fig. 5 is similar to the end-blocks 100 of Fig. 1 to Fig. 5. According to embodiments, the end-block 100 of Fig. 6 further includes a power supply connector 136, wherein the projections of the first fluid conduit 131 and the power supply connector 136 onto the projection plane 60 overlap each other. In other words, the power supply connector 136 extends in the cross-section of Fig. 6 between a fourth minimum axial co-ordinate x₉ and a fourth maximum axial co-ordinate x₁₀, wherein at least one of the forth minimum axial co-ordinate x₉ and the fourth maximum axial co-ordinate x₁₀ lies between the first minimum axial co-ordinate x₁ and the first maximum axial co-ordinate x₃. Typically, the projection of the power supply connector 136 onto the projection plane 60 lies completely within the projection of the first fluid conduit 131 onto the projection plane 60, i.e. x₁ ≤ x₉ ≤ x₃ and x₁ ≤ x₁₀ ≤ x₃.

According to an embodiment, the main body 110 is made of an electrically conducting material, typically a metal, e.g. steel. Thereby, the power supply for the rotatable target may flow from the power supply connector 136, through the base body 110 to one or more sliding electric contacts 135. In addition, using steel as material of the base body 110 ensures high mechanical stability.

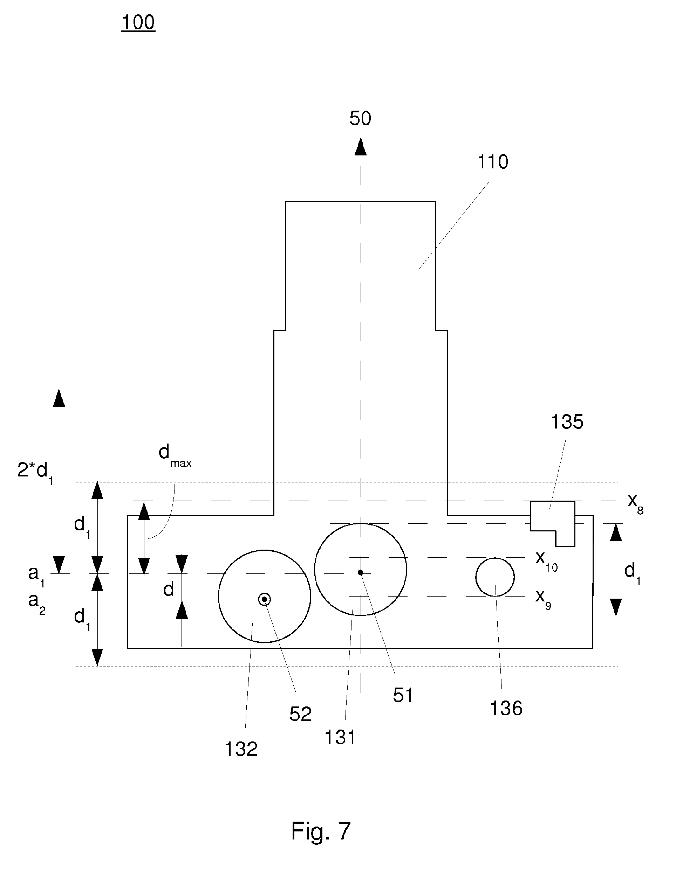

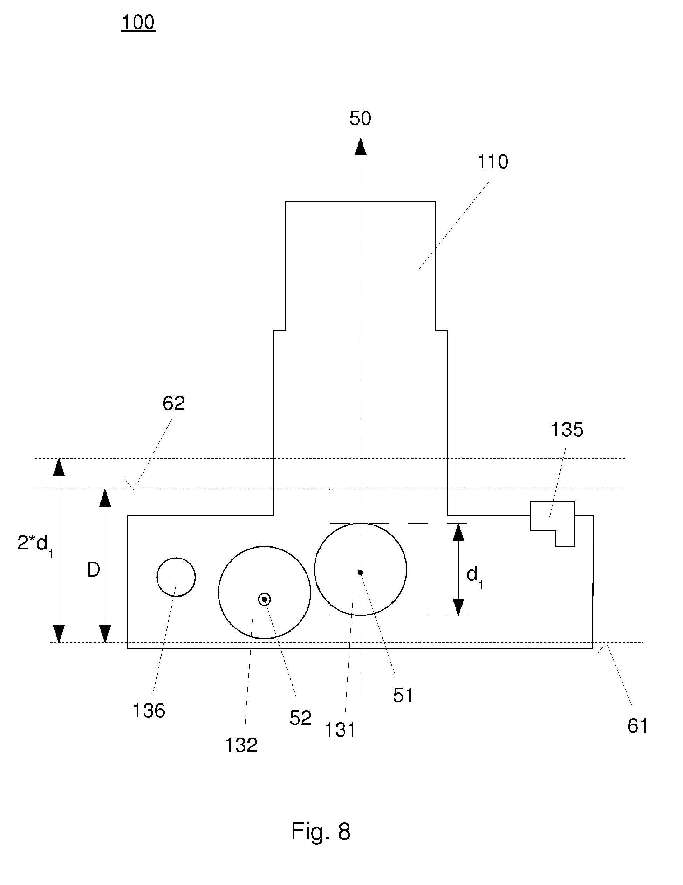

With respect to Figs. 7 and 8 further embodiments of compact end-blocks 100 are described. Fig. 7 schematically illustrates embodiments of an end-block 100 in a cross-section along a direction which is parallel to the rotational axis 50 of a rotatable target.

According to an embodiment, which may be combined with other embodiments disclosed herein, the end-block 100 includes a main body 110, a first fluid conduit 131 having a first outer diameter d₁, and at least a second fluid conduit 132. The first fluid conduit 131 is adapted for fluid connection with the main body 110 at a first axial co-ordinate a₁ and the second fluid conduit 132 is adapted for fluid connection with the main body 110 at a second axial co-ordinate a₂. A distance d between the first axial co-ordinate a₁ and the second axial co-ordinate a₂ is less than the first outer diameter d₁. The axial co-ordinate's a₁ and a₂ are defined by the axial co-ordinates of the longitudinal axes 51 and 52, respectively.

According to an embodiment, which may be combined with other embodiments disclosed herein, the end-block 100 further includes at least one electric contact 135, typically several sliding electric contacts 135, having a maximum axial distance dₘₐₓ to the first longitudinal axes 51 which is smaller than twice the first outer diameter d₁, typically smaller than the first outer diameter d₁.

According to an embodiment, which may be combined with other embodiments disclosed herein, the end-block 100 further includes at least one power supply connector 136 having a fourth minimum axial co-ordinate x₉ and a fourth maximum axial co-ordinate x₁₀. The forth minimum axial co-ordinate x₉ and/or the fourth maximum axial co-ordinate x₁₀ lie between the difference between the first axial co-ordinate a₁ and half of the first outer diameter d₁ and the sum of the first axial co-ordinate a₁ and half of the first outer diameter d₁. Typically, both the fourth minimum axial co-ordinate x₉ and the fourth maximum axial co-ordinate x₁₀ lie within these boundaries, i.e. a₁ - 0.5 *d₁ ≤ x₉ < x₁₀ ≤ a₁ + 0.5 *d₁.

According to an embodiment, which may be combined with other embodiments disclosed herein, the end-block 100 includes two second fluid conduits 132.

Fig. 8 schematically illustrates embodiments of an end-block 100 in a cross-section along a direction which is parallel to a rotational axis 50 of a rotatable target. According to an embodiment, which may be combined with other embodiments disclosed herein, the end-block 100 includes a main body 110, at least a second fluid conduit 132 adapted for fluid connection with the main body 110, and a first fluid conduit 131 adapted for fluid connection with the main body 110 and having a first outer diameter d₁. The first fluid conduit 131 and the at least one second fluid conduit 132 being arranged between a first virtual plane 61 which is perpendicular to the rotational axis 50 and a second virtual plane 62 which is perpendicular to the rotational axis 50, wherein a distance D between the first plane 61 and the second plane 62 is less than twice the first outer diameter d1.

According to an embodiment, which may be combined with other embodiments disclosed herein, the end-block 100 further includes at least one electric contact 135, typically several sliding electric contacts 135, which are arranged between the first plane 61 and the second plane 62.

According to an embodiment, which may be combined with other embodiments disclosed herein, the end-block 100 further includes at least one power supply connector 136 which is in axial direction arranged between the first plane 61 and the second plane 62. Typically, the at least one power supply connector 136 is arranged below the least one electric contact 135.

According to an embodiment, which may be combined with other embodiments disclosed herein, the end-block 100 includes two second fluid conduit 132.

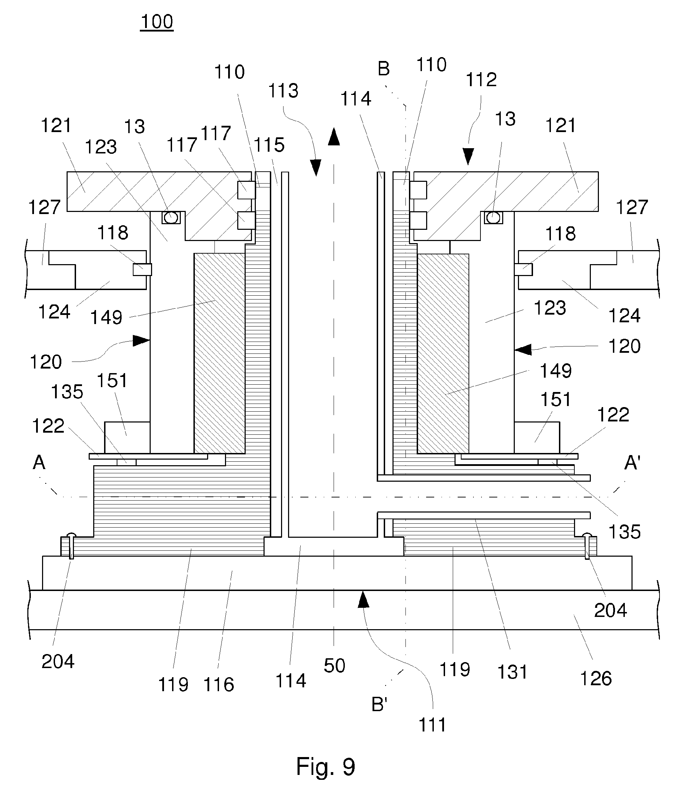

Fig. 9 shows schematically a cross-section of an end-block 100 along a rotational axis 50 of a rotatable target. According to embodiments, cross-sections along the line BB' in Fig. 9 which are orthogonal to the cross-section of Fig. 9 correspond to cross-sections of Figs. 1 to 8.

Typically, the end-block 100 includes an external housing. In the shown cross-section, only parts of a lower wall 126 and an upper wall 127 of the external housing are shown. During sputtering, the external housing does typically not rotate relative the process chamber in which the sputtering is carried out. The process chamber is typically a low pressure chamber and in the following also referred to as vacuum chamber. The external housing may e.g. by attached to a wall of the process chamber. For stability reasons, the external housing is typically made of a metal, e.g. steel, stainless steel or aluminum.

According to embodiments, the end-block 100 has a hollow base body 110 which is rigidly connected to the lower wall 126 of the external housing. Therefore, the base body 110 does typically also not rotate relative to the process chamber during sputtering. In other words, the base body 110 is typically rigidly connected to a non-revolving part of the deposition apparatus.

According to embodiments, a cylindrical cavity 113, which is coaxial to the rotational axis 50, is formed in the base body 110. The cylindrical cavity may also be referred to as radially inward lying part of the base body 110.

According to embodiments, a coolant tube 114 is coaxially inserted into the cylindrical cavity 113. In addition, a hollow cylindrical interspace 115 is typically formed between the coolant tube 114 and the inner walls of the base body 110. The coolant tube 114 and the interspace 115 may be used to support the rotational target with coolant, e.g. water. Typically, cold coolant flows upwards in the interspace 115 and warmed up coolant flows downwards in the coolant tube 114. The flow direction of the coolant may also be reversed.

According to embodiments, a bearing system 149 is arranged around the base body 110. The bearing system 149 is typically coaxial to the rotational axis 50. Typically, the bearing system 149 is adapted to carry both radial and axial loads resulting from the movement of the rotatable target during sputtering. The bearing system 149 typically includes at least one tapered roller bearing, e.g. one or two annular tapered roller bearings. Tapered roller bearings support both radial and axial loads, and typically can carry higher loads than e.g. ball bearings due to greater contact area.

According to embodiments, a rotor 120 is arranged around the bearing system 149. The rotor 120 is in an upper part outside the external housing adapted to receive the rotational target. Thereby, the rotational target may be rotated around the rotational axis 50. Typically, the rotor 120 provides mechanical support for the rotational target, i.e. the rotor 120 typically carries the rotational target and transfers rotational movement to the rotational target during sputtering. Arranging a rotor 120, which is adapted to mechanically support the rotational target, around a non-rotating base body 110 results in a compact and space reduced design of the end-block 100. Thereby, space within the process chamber and hence costs can be reduced.

According to embodiments, the rotor 120 includes a bearing housing 123 which is arranged around and connected to the bearing system 149. Typical cross-sections which are orthogonal to the rotational axis 50 and go through the bearing system 149 may show annular sections of the bearing housing 123, the coolant tube 114 and the base body 110.

According to embodiments, a gear-wheel 151 is arranged around and fastened to the bearing housing 123 to transfer rotational movement to the rotor 120. Typically, the gear-wheel 151 is fastened to a lower part, as shown in Fig. 1, or a middle part of the bearing housing 123. This facilitates mechanical coupling between the gear-wheel 151 and a rotating electric drive through the external housing, e.g. via a belt.

According to embodiments, a target flange 121 is arranged on and vacuum tightly mounted to the bearing housing 123. Typically, an O-ring seal 13 is arranged between the bearing housing 123 and the target flange 121. As the target flange 121 and the bearing housing 123 are typically non-rotatably coupled to each other, a rotatable target mounted on top of the target flange 121 may be rotated by the rotating electric drive.

During sputtering, at least an upper part or the target flange 121 is typically arranged outside the external housing, i.e. in a low pressure or vacuum environment. Different thereto, the internal space of the external housing is typically at normal pressure. To avoid exchange of gas, a seal carrier 124 is, according to embodiments, vacuum-tightly arranged between the upper wall 127 of the external housing and the rotor 120. In a typical embodiment a sliding annular vacuum seal 118 is arranged between the seal carrier 124 and the bearing housing 123. The seal carrier 124 may also be attached to the bearing housing 123 and a sliding annular vacuum seal may be arranged between the seal carrier 124 and the upper wall 127 of the external housing.

According to embodiments, two annular sliding seals 117, e.g. fluid seals 117, are arranged between the target flange 121 and the base body 110. Using at least one annular sliding fluid seal avoids an exchange of coolant, bearing grease and vacuum lubricants, respectively. Thereby, the bearing system 149 is protected against penetration of coolant. Further, penetration of grease into the cooling system is avoided.

According to embodiments, a current collector plate 122 is mounted to the bearing housing 123 at a lower end of the rotor 120, i.e. opposite to the target flange 121. The current collector plate 122 is typically also of an annular shape in a cross-sections which are orthogonal to the rotational axis 50. The current collector plate 122 is typically used to transmit electric current to the rotatable target.

According to embodiments, an insulating plate 116 which is orientated perpendicular to the rotational axis 50 is fastened, typically with screws 204, to a lower part 119 of the base body 110. Thereby, the inner part of the end-block 100 is insulated against and non-rotatably mounted to the external housing.

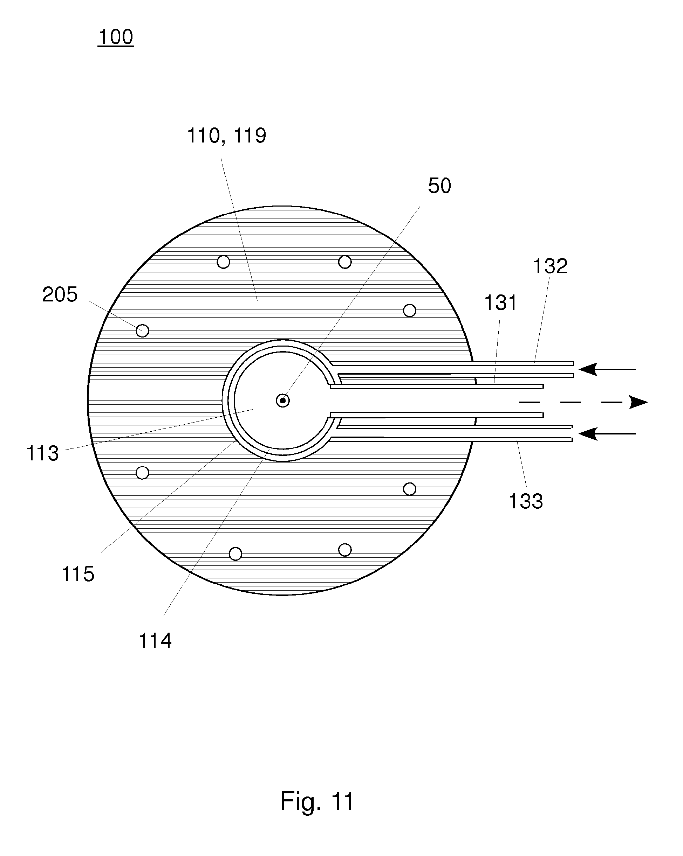

According to embodiments, a coolant supply and an electrical support is realized between the current collector plate 122 and the lower part 119 of the base body 110. Sliding electrical contacts 135 are arranged on the base body 110 and in contact with the current collector plate 122. In the cross- section of Fig. 9 only a tube 131 for receiving the coolant and forming a first fluid conduit 131 is shown. Typically, one or two coolant discharge tubes are also provided but not visible in the cross-section of Fig. 9. The coolant support is explained in more detail with respect to Fig. 11.

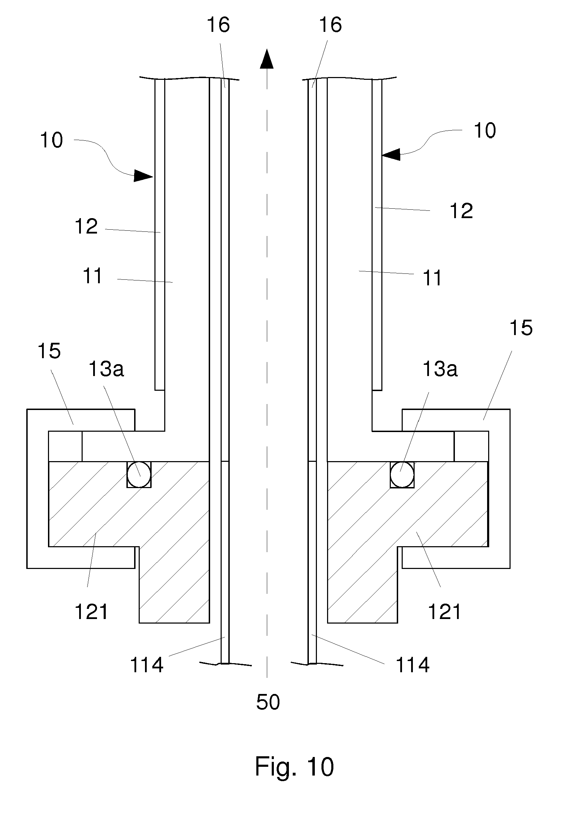

Fig. 10 shows schematically a cross-section of a rotatable target 10 mounted to a target flange 121 of an end-block along the rotational axis 50. According to embodiments, the target flange 121 and the rotatable target 10 are coaxial to each other.

Typically, the rotatable target 10 includes a backing tube 11 and a target tube 12 disposed on the backing tube 11. The term "target tube" as used herein shall embrace any shell, in particular formed as a hollow cylinder, of material suitable to be sputtered.

Support of the target tube may include mechanical support, providing electrical contact and providing cooling of the target tube and the optional magnets.

Alternatively, the rotatable target may also be a monolithic target. In this case, the shape of the rotatable target may be similar to the shape of the rotatable target 10 shown in Fig. 2. The shown adjoining regions 11 and 12 typically form, in this case, a simply-connected region of the same material.

Support of the rotatable target may include at least one of mechanical support, providing electrical contact and providing cooling of the target tube and the optional magnets.

Typically, the rotatable target 10 is fitted to an upper part of the target flange 121 using an annular clamp 15 which presses the rotatable target 10 to the target flange 121. An O-ring seal 13a is typically arranged between the target flange 121 and an adjoining part of the backing tube 11 and the rotatable target 10, respectively. Accordingly, the rotatable target 10 is vacuum-tightly mounted to the target flange 121.

According to embodiments, the rotatable target 10 is vacuum-tightly mounted to the upper part of the target flange 121. This is typically achieved by an annular sealing (not shown). Thereby, fluid leakage to the low pressure process chamber is prevented.

According to embodiments, the rotatable target 10 includes a tubular internal structure 16 that is liquid-tightly mounted to a coolant tube 114 of the end-block for cooling the rotatable target 10, in particular optional magnets (not shown) provided inside the rotatable target 10.

In order to operate the rotatable target 10 as a cathode during sputtering, at least one electric supply (not shown) for the rotatable target 10 is typically also provided through the target flange 121.

According to embodiments, which may be combined with other embodiments disclosed herein, both the target flange and the bearing housing are made of an electrically conducting material, e.g. steel. In these embodiments, the electric current may flow from the current collector plate, through the bearing housing and the target flange to the rotatable target.

According to embodiments, which may be combined with other embodiments disclosed herein, the target flange is adapted to mechanically support the rotatable target. In addition, coolant and electric supply for the target tube is typically provided through the target flange.

Fig. 11 shows schematically a cross-section of the end-block 100 along the line A-A' of Fig. 9. This means that the cross-section of Fig. 9 goes through a lower portion 119 of a main body 110.

Typically, the end-block 100 includes a coolant discharge tube 131 forming the first fluid conduit 131 for receiving a fluid from the rotatable target. The end-block 100 further includes a first and a second coolant supply tubes 132, 133 which form a second and third fluid conduit 132, 133 for providing the fluid to the rotatable target, respectively. The coolant discharge tube 131 and the coolant supply tubes 132, 133 are, in a direction which is orthogonal to the rotational axis 50, fed through respective voids in the base body 110. Typically, the coolant discharge tube 131 and the coolant supply tubes 132, 133 are parallel to each other. The coolant discharge tube 131 leads into an opening of the coolant tube 114 and the coolant supply tubes 132, 133 lead into the annular coolant interspace 115 formed between the base body 110 and coolant tube 114. As indicated by the full arrows, a coolant such as water may be provided to the supply tubes 132. During sputtering, the coolant typically flows through the supply tubes 132 and upwards in the coolant interspace 115 to the rotatable target. The backflow of the warmed-up coolant typically goes downwards through the coolant tube 114 and is discharged in radial direction through the discharge tube 131, as indicated by the dashed arrow. Thereby, a closed coolant circuit may be provided for the rotatable target.

According to embodiments, the flow direction in the closed coolant circuit is reversed. In these embodiments, the end-block 100 includes a coolant tube 131 forming the second fluid conduit for providing the fluid to the rotatable target and two coolant tubes 132, 133 which form two first fluid conduits for receiving a fluid from the rotatable target, respectively. Typically, the second fluid conduit extends radially outward from the rotational axis 50 in theses embodiments.

According to embodiments, the coolant discharge tube 131 and/or the coolant supply tubes 132, 133 are formed at their radial distal end as a fluid adapter for connecting external fluid supply lines.

Typically, the base body 110 includes, in a radially outward lying part, through holes for fastening, typically screwing, the lower part 119 of the base body 110 to an insulating plate.

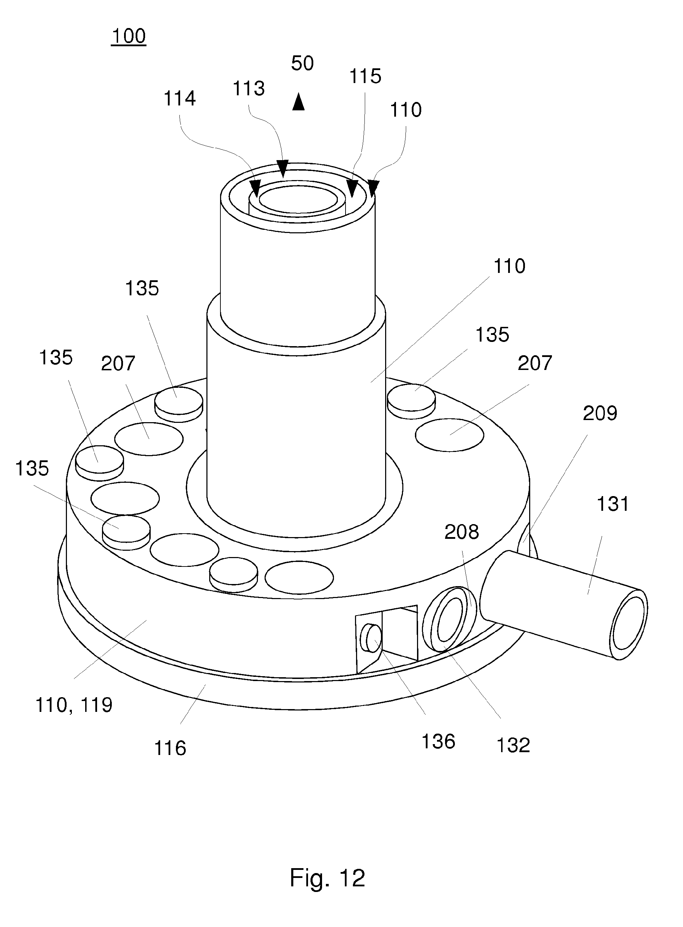

Fig. 12 shows schematically a perspective view of an inner part of an end-block 100 according to embodiments. A cross-sectional view along a rotational axis 50 is typically similar to the cross-section of Fig. 9.

According to embodiments, the end-block 100 includes a hollow main body 110 having a cylindrical cavity 113 which is arranged coaxially to the rotational axis 50. A coolant tube 114 is coaxially inserted into the cylindrical cavity 113. Thereby, a hollow cylindrical interspace 115 is typically formed between the coolant tube 114 and the inner walls of the base body 110. Three voids for receiving fluid tubes are arranged in a lower part 119 of the main body 110. In a radially arranged void a first tube 131 is inserted. The first tube 131 leads into an inner space of the coolant tube 114 and form a first fluid conduit 131 for receiving coolant from the inner space of the coolant tube 114. A second tube 132 is fed into the second void 208. The second tube 132 forms a second fluid conduit 132 for providing the coolant to the interspace 115. In addition, a third tube (not shown) is typically fed into a third void 209. The third tube forms a third fluid conduit 132 for providing the coolant to the interspace 115. Thereby, a rotatable target which is mounted on the main body 110, as explained with respect to Fig. 10, may be supported with coolant in a closed coolant circuit.

According to embodiments, sliding electric contacts 135 are plugged into holes on top of the lower part 119. Further, a power supply connector 136 is arranged in the lower part 119 and below the sliding electric contacts 135.

According to embodiments, the lower part 119 of the main body 110 includes through holes 207, through which the main body 110 may be screwed to an insulating plate 116.

According to embodiments, which may be combined with other embodiments disclosed herein, the first fluid conduit, the second fluid conduit, the third fluid conduit, the power supply connector and the sliding electric contacts are arranged in a virtual disc which orientated perpendicular to the rotational axis and has an extension in direction of the rotational axis that is lower than twice the extension of the first fluid conduit in direction of the rotational axis. Typically, the axial extension of the virtual disc is lower than 1.5 times the axial extension of the first fluid conduit.

According to embodiments, which may be combined with other embodiments disclosed herein, the lower part of the base body is a ring-shaped body and includes a first fluid conduit and at least one second fluid conduit. The ring-shaped body is orientated perpendicular to the rotational axis and has an extension in direction of the rotational axis that is lower than twice the extension of the first fluid conduit in direction of the rotational axis. Typically, the axial extension of the ring-shaped body is lower than 1.5 times the axial extension of the first fluid conduit. The first fluid conduit and the at least one second fluid conduit are orthogonal to the rotational axis. Typically, a power supply connector is provided in the lower part of the base body and at least one sliding electric contacts is arranged on the ring-shaped body.

According to embodiments, which may be combined with other embodiments disclosed herein, the main body is made of a conductive material such as steel. Thereby, a sufficient mechanical stability of main body is achieved. Further, the sliding electric contacts may be electrically connected with the power supply connector through the material of the main body.

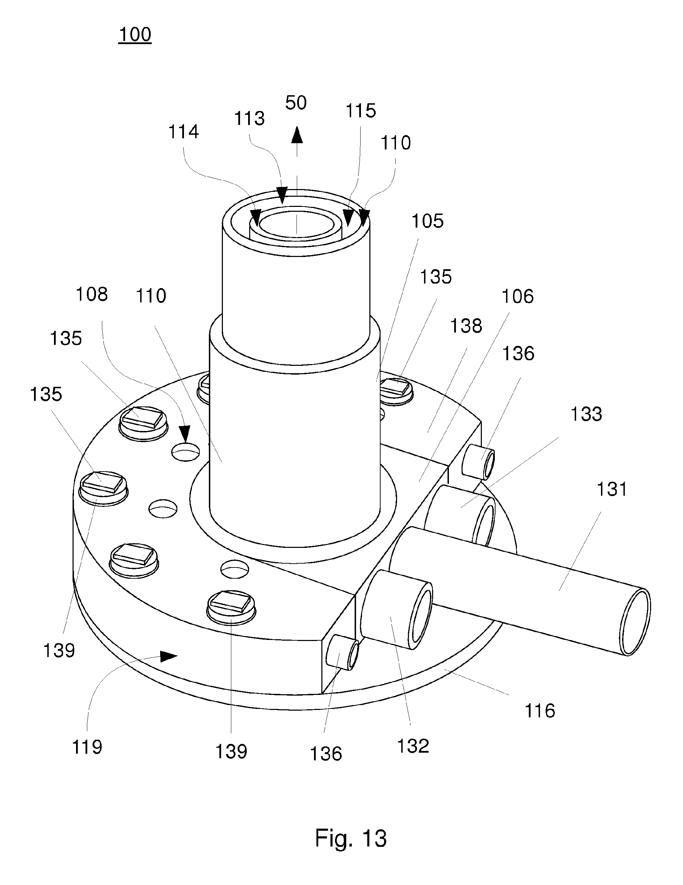

Fig. 13 shows schematically a perspective view of an inner part of an end-block 100 according to embodiments. A cross-sectional view along the rotational axis 50 is typically similar to the cross-section of Fig. 9.

According to embodiments, the end-block 100 includes a hollow main body 110 with a cylindrical cavity 113 which is arranged coaxially to the rotational axis 50. A coolant tube 114 is coaxially inserted into the cylindrical cavity 113. Thereby, a hollow cylindrical interspace 115 is typically formed between the coolant tube 114 and the inner walls of the base body 110. In a lower part 119 of the main body 110 three tubes 131, 132 and 133 voids are arranged for receiving fluid tubes. In a radially arranged void a first tube 131 is fed through a fluidic adapter block 106. A first tube 131 radially leads into an inner space of the coolant tube 114 and forms a first fluid conduit 131 for receiving a coolant from the inner space of the coolant tube 114. A second tube 132 and a third tube 133 are inserted into the fluidic adapter block 106 and lead to the interspace 115. The second tube 132 and the third tube 133 form a second fluid conduit 132 and third fluid conduit 133, respectively, for providing the coolant to the interspace 115. Thereby, a rotatable target which is mounted on the main body 110, as explained with respect to Fig. 10, may be supported with coolant in a closed coolant circuit. Typically, the first fluid conduit 131, second fluid conduit 132 and the third fluid conduit 133 are substantially parallel to each other.

According to embodiments, an insulated horseshoe-shaped conductor body 138 is arranged partially around a radially inward lying part 105 of the main body 110 and the fluidic adapter block 106. The insulated horseshoe-shaped conductor body 138 may form a part of the main body 110.

According to embodiments, sliding electric contacts 135 are arranged through holes on the electrically conductive body 139 of the horseshoe-shaped conductor body 138. Further, two power supply connectors 136 are mounted to the conductor body 138.

According to embodiments, the insulated horseshoe-shaped conductor body 138 includes through holes 207, through which the main body 110 may be screwed to an insulating plate 116.

According to embodiments, which may be combined with other embodiments disclosed herein, the first fluid conduit, the second fluid conduit, the third fluid conduit, the power supply connectors and the sliding electric contacts are arranged between a first plane which is perpendicular to the rotational axis and a second plane which is perpendicular to the rotational axis, wherein the distance between the first plane and the second plane is smaller than two times, typically smaller than about 1.5 times, the extension of the first fluid conduit in direction of the rotational axis.

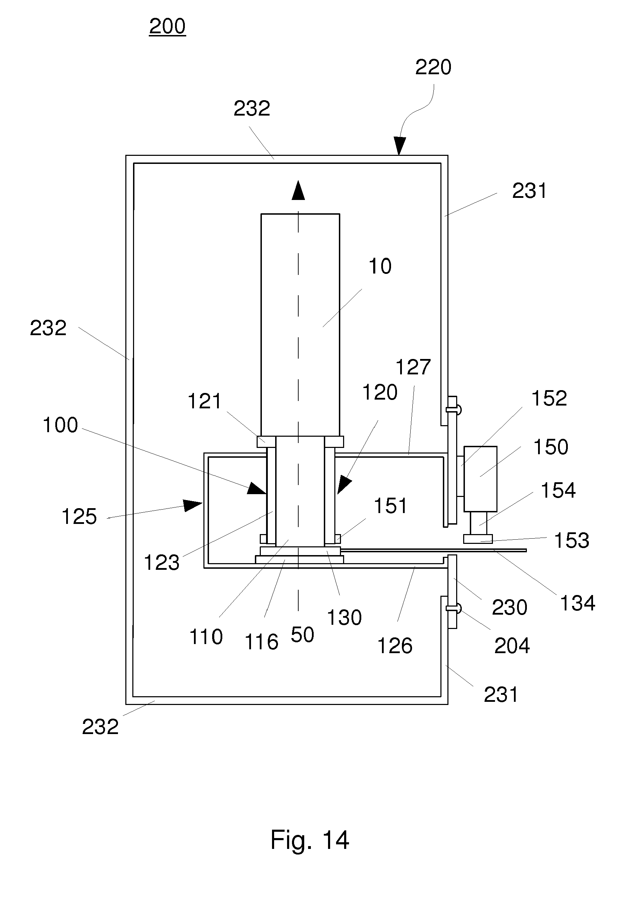

Fig. 14 shows schematically a cross-section of a sputtering installation 200 along the rotational axis 50 according to embodiments. The sputtering installation 200 typically includes a process chamber 220 formed by walls 231 and 232. Thereby, according to typical embodiments, the axis 50 of the cathode, the target, or the backing tube is essentially parallel to the wall 231 the end-block 100 is attached to. Thereby, a drop-in configuration of the cathode is realized.

According to embodiments, at least one end-block 100, as explained with reference to the previous Figures, is mounted into the process chamber 220 such that the base body 110 of the end-block 100 is not rotatably relative to the walls 231 of the process chamber 220. The base body 110 is typically fastened via an insulating plate 116 and to a flap or door 230 of the process chamber 220. During sputtering, the flap or door 230 is closed. Accordingly, the base body 110 is typically stationary, at least non-rotatable, during sputtering. Alternatively, the external housing 125 may be fastened directly to a wall 231 of the process chamber 220.

According to embodiments, a rotating drive 150, typically an electrical drive, is arranged outside the process chamber 220 via a mounting support 152. The rotating drive 150 may, however also be placed within the external housing 125. Typically, the rotating drive 150 drives the rotatable target 10 during sputtering via its motor axis 154, a pinion 153 connected thereto and a chain or a toothed belt (not shown) which loops around the pinion 153 and a gear-wheel 151 attached to a bearing housing 123 of the rotor 120.

Typically, coolant support tubes 134 and/or electrical support lines 134 are fed from the coolant supply and discharge unit 130 and/or an electrical support unit 130 through the external housing 125 to the outside of the process chamber 220.

The rotatable target 10 is typically supported by the end-block 100 in a cantilevered arrangement above a substrate (not shown). In addition, the rotatable target 10 may be further supported at its upper end.

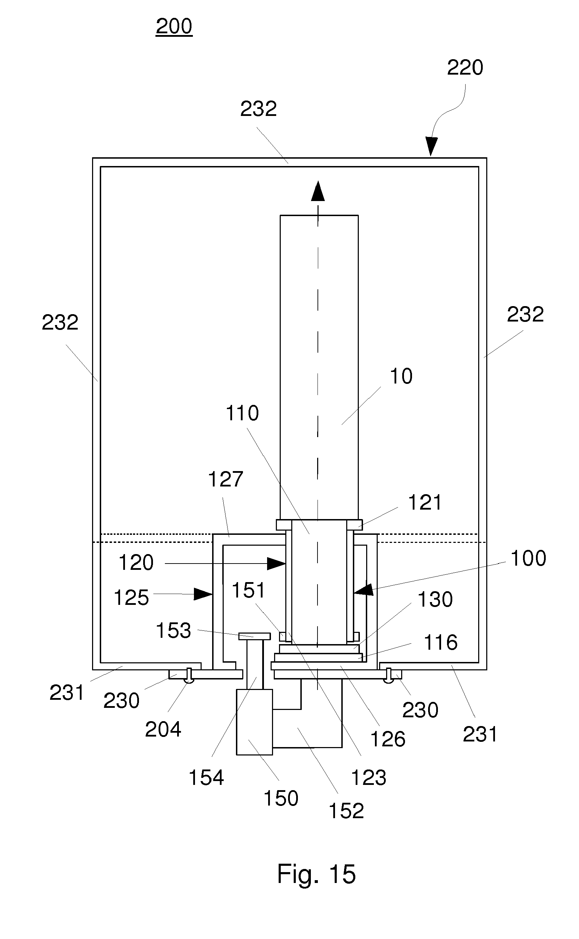

Fig. 15 shows schematically a cross-section of a sputtering installation 200 according to embodiments. The sputtering installation 200 of Fig. 15 is similar to the sputtering installation of Fig. 14. However, the insulating plate 116 in Fig. 15 is orientated parallel to the wall 231 and flap 230, respectively, to which the end-block 100 is mounted. Different thereto, the insulating plate 116 in Fig. 14 is orientated perpendicular to the wall 231 and flap 230, respectively, to which the end-block 100, 101 is mounted. Further, the motor axis 154 extends into the external housing 125 in the embodiment of Fig. 15. For sake of clarity, coolant support tubes and electrical support lines, which are typically also used in the embodiment of Fig. 15, are not shown.

According to embodiments, the lower wall 126 of the external housing 125 is mounted to the wall 231 or to the door 230 and flap 230, respectively, as shown in Fig. 15.

According to other embodiments, the end-block 100 is mounted to the wall 231 such that the wall 231 of the vacuum chamber 220 and the upper wall 127 of the external housing 125 form an essentially flat transition region inside the vacuum chamber 220 or a transition region having a small step only. This is indicated by the dotted horizontal lines in Fig. 15. In these embodiments, the internal volume of the vacuum chamber 220 may be reduced.

The arrangement of Fig. 15 is typically used for sputtering installations in which the substrate is orientated horizontally with respect to gravity. The arrangement of Fig. 6 may be used for horizontally and vertically orientated substrates.

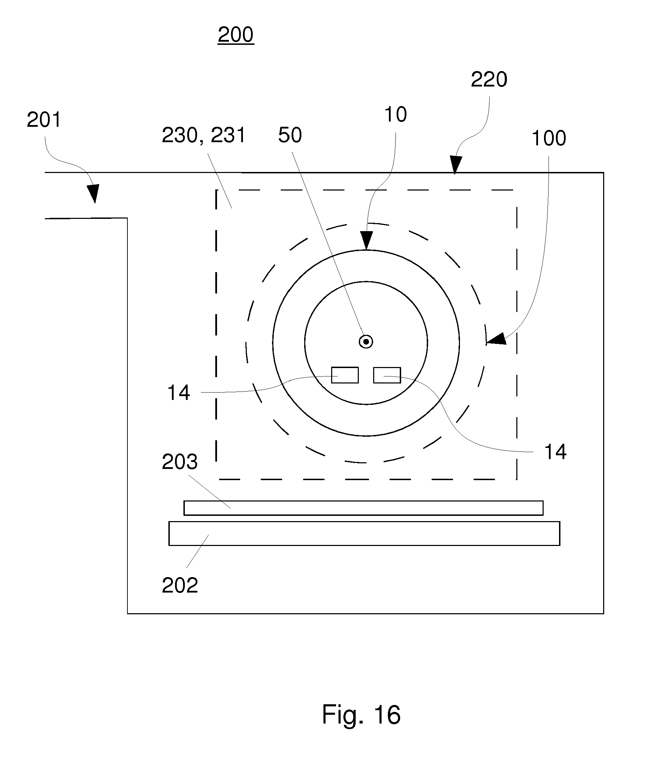

Fig. 16 illustrates a sputtering installation 200 as shown in Fig. 14 and 15. The schematic cross-section of Fig. 16 is orthogonal to the cross-section of Fig. 14 and 15, respectively. According to an embodiment, the sputtering installation 200 has a vacuum chamber 220 including a gas inlet 201 for providing processing gas, for example argon, to the vacuum chamber 220. The vacuum chamber 220 further includes a substrate support 202 and a substrate 203 arranged on the substrate support 202. Further, the vacuum chamber 220 includes a rotatable target 10, typically in a cantilevered arrangement above the substrate 203.

Typically, a high voltage difference is applied between the rotatable target 10 operating as a cathode and the substrate support 202 operating as an anode. The plasma is typically formed by impact ionization of accelerated electrons with e.g. Argon atoms. The formed Argon ions are accelerated in direction of rotatable target 10 such that particles, typically atoms, of the rotatable target 10 are sputtered and subsequently deposited on the substrate 203.

In embodiments, other suitable gases, e.g. other inert gases such as krypton or a reactive gas such as oxygen or nitrogen may be used to create the plasma. According to typical embodiments, which can be combined with other embodiments described herein, the pressure in the plasma area can be about 10⁻⁴ mbar to about 10⁻² mbar, typically about 10⁻³ mbar. In a further embodiment, the vacuum chamber 220 may include one or more openings and/or valves for introducing or retracting the substrate 203 in or out of the vacuum chamber 220.

Magnetron sputtering is particularly advantageous in that its deposition rates are rather high. By arranging one or more magnets 14 inside the rotatable target 10 free electrons within the generated magnetic field directly below the target surface may be trapped. This enhances the probability of ionizing the gas molecules typically by several orders of magnitude. In turn, the deposition rate may be increased significantly. Depending on the application and the material to be sputtered, stationary or time varying magnetic fields may be used. Furthermore, a cooling fluid is typically circulating within rotatable target 10 for cooling the magnets 224 and/ or the target 10.

The rotatable target 100 is typically supported by an end-block 100 which is not visible in the shown cross-section and therefore drawn as a dashed circle.

Typically, the end-block 100 is non-rotatably mounted to a wall 230 or door 231 or flap 231 of the process chamber 220 which is not visible in the shown cross-section and therefore drawn as a rectangle.

The end-block typically includes a base body which is adapted to be rigidly coupled to a non-revolving part such as a wall, door or flap of the sputtering installation.

The end-block includes a first fluid conduit in the main body for receiving a fluid from the rotatable target and a second fluid conduit in the main body for providing the fluid to the rotatable target, wherein the projection of the second fluid conduit onto a projection plane that extends in the direction of the rotational axis lies within the projection of the first fluid conduit onto the projection plane.

At least one of the first fluid conduit and the second fluid conduit extends radially outward from the rotational axis.

According to embodiments, which may be combined with other embodiments disclosed herein, the base body includes a cylindrical cavity which is arranged coaxially to the rotational axis, and into which a coolant tube is coaxially inserted, wherein the first fluid conduit leads into the coolant tube.

According to embodiments, which may be combined with other embodiments disclosed herein, a hollow cylindrical interspace is formed between the coolant tube and the inner walls of the base body, and wherein the second fluid conduit leads into the interspace.

According to embodiments, which may be combined with other embodiments disclosed herein, the end-block further includes a third fluid conduit in the main body for fluid support of the rotatable target. The third conduit is oriented perpendicular to the rotational axis. The projections of the first fluid conduit and the third fluid conduit onto a plane that extends in the direction of the rotational axis overlap each other.

According to embodiments, which may be combined with other embodiments disclosed herein, the first fluid conduit has a first sectional area, the second fluid conduit has a second sectional area and the third fluid conduit has a third sectional area. The first sectional area approximately matches the sum of the second sectional area and the third sectional area.

According to embodiments, which may be combined with other embodiments disclosed herein, the end-block further includes at least one electric contact having a maximum axial co-ordinate which is less than the sum of the maximum axial co-ordinate of the first fluid conduit and the extension in axial direction of the first fluid conduit.

According to embodiments, which may be combined with other embodiments disclosed herein, the end-block further includes at least one power supply connector. The projections of the first fluid conduit and the at least one power supply connector onto a projection plane that extends in the direction of the rotational axis overlap each other.

Even though each of the Figs. 14 to 16 show only one rotatable target, according to different embodiments, which may be combined with other embodiments disclosed herein, two or more rotatable targets may be supported by respective cathode drive-blocks and disposed in the vacuum chamber. Typically, the cylindrical axes of the two or more rotatable targets are substantially parallel, i.e. parallel within an angular accuracy of at least 5°, more typically within an angular accuracy of at least 1°.

This written description uses examples to disclose the invention, including the best mode, and also to enable any person skilled in the art to practice the described subject-matter, including making and using any devices or systems and performing any incorporated methods. Especially, mutually non-exclusive features of the embodiments described above may be combined with each other. The invention is defined by the claims.

## Claims

1. A device (100) arranged to support a rotatable target (10) of a deposition apparatus (200) for sputtering material on a substrate, the device (100) having a longitudinal axis forming a rotational axis (50) of the rotatable target (10), and the device (100) comprising:
- a main body (110);
- a first fluid conduit (131) in the main body (110) for receiving a fluid from the rotatable target (10), the first fluid conduit (131) being oriented in a direction orthogonal to the rotational axis (50); and
- a second fluid conduit (132) in the main body (110) for providing the fluid to the rotatable target (10), the second conduit (132) being oriented in a direction orthogonal to the rotational axis (50);
wherein the projections of the first fluid conduit (131) and the second fluid conduit (132) onto a projection plane (60) that extends in the direction of the rotational axis (50) overlap each other,
**characterized in that** one of the first fluid conduit (131) and the second fluid conduit (132) extends radially outward from the rotational axis (50).

2. The device (100) of claim 1, wherein only one of the first fluid conduit (131) and the second fluid conduit (132) extends radially outward from the rotational axis (50).

3. The device (100) of claim 1 or 2, wherein the projection of the second fluid conduit (132) onto the projection plane lies within the projection of the first fluid conduit (131) onto the projection plane.

4. The device (100) of any of the preceding claims, wherein the base body (110) comprises a cylindrical cavity (113) which is arranged coaxially to the rotational axis (50), further comprising a coolant tube (114) coaxially inserted into the cylindrical cavity (113), wherein the first fluid conduit (131) leads into the coolant tube (114).

5. The device (100) of claim 4, wherein a hollow cylindrical interspace (115) is formed between the coolant tube (114) and the inner walls of the base body (110), and wherein the second fluid conduit (132) leads into the interspace (115).

6. The device (100) of any of the preceding claims, further comprising a third fluid conduit (133) in the main body (110) for fluid support of the rotatable target (10), the third conduit (133) being oriented in a direction orthogonal to the rotational axis (50), wherein the projections of the first fluid conduit (131) and the third fluid conduit (132) onto the projection plane overlap each other.

7. The device (100) of claim 5 and 6, wherein the third fluid conduit (133) leads into the interspace (115).

8. The device (100) of claim 6 or 7, wherein the first fluid conduit (131) comprises a first sectional area, wherein the second fluid conduit (132) comprises a second sectional area, wherein the third fluid conduit (133) comprises a third sectional area, and wherein the first sectional area approximately matches the sum of the second sectional area and the third sectional area.

9. The device (100) of any of the preceding claims, wherein the first fluid conduit (132) has a first extension in axial direction (d1) and a first maximum axial co-ordinate (x3), further comprising at least one electric contact (135), wherein the at least one electric contact (135) has a maximum axial co-ordinate (x8) which is less than the sum of the first maximum axial co-ordinate (x3) and the first extension in axial direction (d1).

10. The device (100) of claim 9, further comprising a current collector plate (122) arranged pivotable around the main body (110) and being in mechanical contact with the at least one electric contact (135).

11. The device (100) of any of the preceding claims, further comprising at least one power supply connector (136), wherein the projections of the first fluid conduit (131) and the at least one power supply connector (136) onto the projection plane overlap each other.

12. The device (100) of any of the preceding claims, wherein the main body (110) comprises an electrically conducting material.

13. The device (100) of any of the preceding claims, further comprising a target flange (121) arranged pivotable around the main body (110) and being adapted to mechanically support the rotatable target (10).

14. The device (100) of any of the preceding claims, further comprising an insulating plate (116) which is orientated perpendicular to the rotational axis (50), onto which the main body (110) is mounted, and which is adapted to be fastened to a non-revolving part of the deposition apparatus (200).

15. A deposition apparatus (200) for sputtering material on a substrate, comprising at least one device (100) of any of the preceding claims.

## Patentansprüche

1. Vorrichtung (100), die dazu eingerichtet ist, ein drehbares Target (10) einer Abscheidungsvorrichtung (200) zum Aufsputtern eines Materials auf ein Substrat abzustützen, wobei die Vorrichtung (100) eine Längsachse hat, die eine Drehachse (50) des drehbaren Targets (10) bildet, und wobei die Vorrichtung (100) aufweist:
- einen Hauptkörper (110);
- einen ersten Fluidkanal (131) im Hauptkörper (110), um ein Fluid vom drehbaren Target (10) aufzunehmen, wobei der erste Fluidkanal (131) in einer zur Drehachse (50) orthogonalen Richtung ausgerichtet ist; und
- einen zweiten Fluidkanal (132) im Hautkörper (110), um das Fluid dem drehbaren Target (10) bereitzustellen, wobei der zweite Fluidkanal (132) in einer zur Drehachse (50) orthogonalen Richtung ausgerichtet ist;
wobei die Projektionen des ersten Fluidkanals (131) und des zweiten Fluidkanals (132) auf einer Projektionsebene (60), die sich in der Richtung der Drehachse (50) erstreckt, einander überlappen,
**dadurch gekennzeichnet, dass** sich der erste Fluidkanal (131) und/oder der zweite Fluidkanal (132) von der Drehachse (50) radial nach außen erstreckt.

2. Vorrichtung (100) nach Anspruch 1, wobei sich nur ein Fluidkanal, der erste Fluidkanal (131) oder der zweite Fluidkanal (132), von der Drehachse (50) radial nach außen erstreckt.

3. Vorrichtung (100) nach Anspruch 1 oder 2, wobei die Projektion des zweiten Fluidkanals (132) auf der Projektionsebene innerhalb der Projektion des ersten Fluidkanals (131) auf der Projektionsebene liegt.

4. Vorrichtung (100) nach einem der vorhergehenden Ansprüche, wobei der Hauptkörper (110) einen zylindrischen Hohlraum (113) aufweist, der koaxial zur Drehachse (50) angeordnet ist, darüber hinaus ein Kühlmittelrohr (114) aufweisend, das koaxial in den zylindrischen Hohlraum (113) eingeführt ist, wobei der erste Fluidkanal (131) in das Kühlmittelrohr (114) führt.

5. Vorrichtung (100) nach Anspruch 4, wobei ein hohlzylindrischer Zwischenraum (115) zwischen dem Kühlmittelrohr (114) und den Innenwänden des Hauptkörpers (110) gebildet ist, und wobei der zweite Fluidkanal (132) in den Zwischenraum (115) führt.

6. Vorrichtung nach einem der vorhergehenden Ansprüche, darüber hinaus einen dritten Fluidkanal (133) im Hauptkörper (110) zur fluidbasierten Unterstützung des drehbaren Targets (10) aufweisend, wobei der dritte Kanal (133) in einer zur Drehachse (50) orthogonalen Richtung ausgerichtet ist, wobei die Projektionen des ersten Fluidkanals (131) und des dritten Fluidkanals (132) auf der Projektionsebene einander überlappen.

7. Vorrichtung (100) nach Anspruch 5 und 6, wobei der dritte Fluidkanal (133) in den Zwischenraum (115) führt.

8. Vorrichtung (100) nach Anspruch 6 oder 7, wobei der erste Fluidkanal (131) eine erste Querschnittsfläche aufweist, wobei der zweite Fluidkanal (132) eine zweite Querschnittsfläche aufweist, wobei der dritte Fluidkanal (133) eine dritte Querschnittsfläche aufweist, und wobei die erste Querschnittsfläche in etwa der Summe der zweiten Querschnittsfläche und der dritten Querschnittsfläche entspricht.

9. Vorrichtung (100) nach einem der vorhergehenden Ansprüche, wobei der erste Fluidkanal (132) eine erste Erstreckung in axialer Richtung (d1) und eine erste maximale axiale Koordinate (x3) hat, darüber hinaus mindestens einen elektrischen Kontakt (135) umfassend, wobei der mindestens eine elektrische Kontakt (135) eine maximale axiale Koordinate (x8) hat, die kleiner ist als die Summe der ersten maximalen axialen Koordinate (x3) und der ersten Erstreckung in axialer Richtung (d1).

10. Vorrichtung (100) nach Anspruch 9, darüber hinaus eine Stromabnehmerplatte (122) aufweisend, die verschwenkbar um den Hauptkörper (110) angeordnet und in mechanischem Kontakt mit dem mindestens einen elektrischen Kontakt (135) ist.

11. Vorrichtung (100) nach einem der vorhergehenden Ansprüche, darüber hinaus mindestens einen Energieversorgungssteckverbinder (136) aufweisend, wobei die Projektionen des ersten Fluidkanals (131) und des mindestens einen Energieversorgungssteckverbinders (136) auf der Projektionsebene einander überlappen.

12. Vorrichtung (100) nach einem der vorhergehenden Ansprüche, wobei der Hauptkörper (110) ein elektrisch leitendes Material aufweist.

13. Vorrichtung (100) nach einem der vorhergehenden Ansprüche, darüber hinaus einen Target-Flansch (121) aufweisend, der verschwenkbar um den Hauptkörper (110) angeordnet und dazu angepasst ist, das drehbare Target (10) mechanisch abzustützen.

14. Vorrichtung (100) nach einem der vorhergehenden Ansprüche, darüber hinaus eine Isolierplatte (116) aufweisend, die senkrecht zur Drehachse (50) ausgerichtet ist, und auf welcher der Hauptkörper (110) montiert ist, und die dazu angepasst ist, an einem nicht umlaufenden Teil der Abscheidungsvorrichtung (200) befestigt zu sein.

15. Abscheidungsvorrichtung (200) zum Aufsputtern eines Materials auf ein Substrat, mindestens eine Vorrichtung (100) nach einem der vorhergehenden Ansprüche umfassend.

## Revendications

1. Dispositif (100) agencé pour supporter une cible rotative (10) d'un appareil de dépôt (200) destiné à pulvériser du matériau sur un substrat, le dispositif (100) ayant un axe longitudinal formant un axe de rotation (50) de la cible rotative (10), et le dispositif (100) comprenant :
- un corps principal (110) ;
- un premier conduit de fluide (131) dans le corps principal (110), destiné à recevoir un fluide provenant de la cible rotative (10), le premier conduit de fluide (131) étant orienté dans une direction orthogonale à l'axe de rotation (50) ; et
- un deuxième conduit de fluide (132) dans le corps principal (110), destiné à fournir le fluide à la cible rotative (10), le deuxième conduit (132) étant orienté dans une direction orthogonale à l'axe de rotation (50) ;
sachant que les projections du premier conduit de fluide (131) et du deuxième conduit de fluide (132) sur un plan de projection (60) qui s'étend dans la direction de l'axe de rotation (50) se chevauchent l'une l'autre,
**caractérisé en ce que** l'un du premier conduit de fluide (131) et du deuxième conduit de fluide (132) s'étend radialement vers l'extérieur à partir de l'axe de rotation (50).

2. Le dispositif (100) de la revendication 1, sachant que seul l'un du premier conduit de fluide (131) et du deuxième conduit de fluide (132) s'étend radialement vers l'extérieur à partir de l'axe de rotation (50).

3. Le dispositif (100) de la revendication 1 ou 2, sachant que la projection du deuxième conduit de fluide (132) sur le plan de projection est située à l'intérieur de la projection du premier conduit de fluide (131) sur le plan de projection.

4. Le dispositif (100) de l'une quelconque des revendications précédentes, sachant que le corps principal (110) comprend une cavité cylindrique (113) qui est agencée coaxialement à l'axe de rotation (50), comprenant en outre un tube de réfrigérant (114) coaxialement inséré dans la cavité cylindrique (113), sachant que le premier conduit de fluide (131) mène dans le tube de réfrigérant (114).

5. Le dispositif (100) de la revendication 4, sachant qu'un espace intercalaire cylindrique creux (115) est formé entre le tube de réfrigérant (114) et les parois intérieures du corps principal (110), et sachant que le deuxième conduit de fluide (132) mène dans l'espace intercalaire (115).

6. Le dispositif (100) de l'une quelconque des revendications précédentes, comprenant en outre un troisième conduit de fluide (133) dans le corps principal (110) pour le support fluidique de la cible rotative (10), le troisième conduit (133) étant orienté dans une direction orthogonale à l'axe de rotation (50), sachant que les projections du premier conduit de fluide (131) et du troisième conduit de fluide (132) sur le plan de projection se chevauchent l'une l'autre.

7. Le dispositif (100) des revendications 5 et 6, sachant que le troisième conduit de fluide (133) mène dans l'espace intercalaire (115).

8. Le dispositif (100) de la revendication 6 ou 7, sachant que le premier conduit de fluide (131) comprend une première aire de section, sachant que le deuxième conduit de fluide (132) comprend une deuxième aire de section, sachant que le troisième conduit de fluide (133) comprend une troisième aire de section, et sachant que la première aire de section correspond approximativement à la somme de la deuxième aire de section et de la troisième aire de section.

9. Le dispositif (100) de l'une quelconque des revendications précédentes, sachant que le premier conduit de fluide (132) présente une première extension en direction axiale (d1) et une première coordonnée axiale maximale (x3), comprenant en outre au moins un contact électrique (135), sachant que l'au moins un contact électrique (135) présente une coordonnée axiale maximale (x8) qui est inférieure à la somme de la première coordonnée axiale maximale (x3) et de la première extension en direction axiale (d1).

10. Le dispositif (100) de la revendication 9, comprenant en outre une plaque collectrice de courant (122) agencée de manière pivotante autour du corps principal (110) et étant en contact mécanique avec l'au moins un contact électrique (135).

11. Le dispositif (100) de l'une quelconque des revendications précédentes, comprenant en outre au moins un connecteur d'alimentation en puissance (136), sachant que les projections du premier conduit de fluide (131) et de l'au moins un connecteur d'alimentation en puissance (136) sur le plan de projection se chevauchent l'une l'autre.

12. Le dispositif (100) de l'une quelconque des revendications précédentes, sachant que le corps principal (110) comprend un matériau électriquement conducteur.

13. Le dispositif (100) de l'une quelconque des revendications précédentes, comprenant en outre une bride cible (121) agencée de manière pivotante autour du corps principal (110) et étant apte à supporter mécaniquement la cible rotative (10).

14. Le dispositif (100) de l'une quelconque des revendications précédentes, comprenant en outre une plaque isolante (116) qui est orientée perpendiculairement à l'axe de rotation (50), sur laquelle le corps principal (110) est monté, et qui est apte à être fixée sur une partie non tournante de l'appareil de dépôt (200).

15. Appareil de dépôt (200) destiné à pulvériser du matériau sur un substrat, comprenant au moins un dispositif (100) de l'une quelconque des revendications précédentes.
